# FASCICULE DE BREVET EUROPEEN

(11) **EP 4 348 703 B1**
(45) Date de publication et mention de la délivrance du brevet: **02.07.2025**
(21) Numéro de dépôt: 22733193.1
(22) Date de dépôt: 24.05.2022
(51) Int. Cl.: H01L 21/67, H01L 21/683

(54) **PROCÉDÉ ET ORGANE DE MANIPULATION D'UN DISPOSITIF ÉLECTRONIQUE**
VERFAHREN UND ELEMENT ZUR HANDHABUNG EINER ELEKTRONISCHEN VORRICHTUNG
METHOD AND MEMBER FOR HANDLING AN ELECTRONIC DEVICE

(30) Priorité: 31.05.2021 FR 2105708
(43) Date de publication de la demande: 10.04.2024
(73) Titulaire: Aledia, 38130 Échirolles (FR)
(72) Inventeur: LINCHENEAU, Christophe, 38430 Moirans (FR); CAICEDO, Nohora, 38100 Grenoble (FR)
(74) Mandataire: Germain Maureau
(86) Numéro de dépôt international: PCT/FR2022/050987
(87) Numéro de publication internationale: WO 2022/254125

(56) Documents cités:
- WO-A1-2020/103365
- WO-A1-2020/168174
- US-A1- 2005 148 106
- US-A1- 2018 261 582

## Description

### Domaine technique de l'invention

La présente invention concerne un organe de manipulation d'au moins un dispositif électronique.

L'invention concerne aussi un procédé de manipulation d'un tel dispositif électronique.

### Etat de la technique

Dans le domaine des écrans d'affichage lumineux, les éléments lumineux constituants l'écran doivent être agencés de façon matricielle d'une manière de plus en plus précise à mesure que la résolution des écrans augmente. Ces éléments lumineux comprennent chacun au moins une diode électroluminescente et sont organisés sous la forme d'un pixel multicolore ou sous la forme d'un sous-pixel monochrome.

Il est connu de produire les diodes électroluminescentes sur un support initial sous la forme d'un substrat de silicium ou de saphir et de les reporter, sur un support de réception différent du support initial et destiné à constituer, après ce transfert, l'écran d'affichage lumineux.

Le transfert d'une grande quantité de diodes électroluminescentes entre le support initial et le substrat d'écran soulève de nombreux challenges techniques. En effet, la sélection d'un grand nombre de diodes suivant un écartement déterminé à des distances très faibles est complexe et implique parfois l'utilisation de technique comme la thermocompression qui peut conduire à une détérioration des diodes électroluminescentes. Par ailleurs, des diodes peuvent être naturellement endommagées dans le processus général de fabrication. Le transfert de masse implique donc parfois le transfert de diodes précédemment endommagées qui sont déposées sur l'écran et constituent des points noirs sur le dispositif final.

Pour résoudre ce problème, il est possible de procéder à une réparation ou un changement des diodes défectueuses. Bien que cette méthode permette de diminuer le nombre de points noirs, elle implique des étapes supplémentaires de fabrication, ce qui peut grever les coûts et est fastidieux à implémenter.

Le document suivant est mentionné comme illustration pertinente de l'état de l'art:

WO 2020/168174 A1 décrit des bandes à libération dynamique pour assemblage de composants distincts et au moins une méthode d'utilisation desdites bandes

Les documents suivants sont aussi mentionnés comme illustration complémentaire de l'état de l'art.
WO 2020/103365 A1
US 2018/261582 A1

### Objet de l'invention

La présente invention, définie par le jeu de revendications annexé, a pour but de proposer une solution qui réponde à tout ou partie des problèmes précités.

Ce but peut être atteint grâce à la mise en œuvre d'un organe de manipulation apte à manipuler au moins un dispositif électronique. L'organe de manipulation comprend un corps présentant une surface de contact, ledit organe de manipulation comprenant en outre une pluralité de premières molécules d'interaction ayant une aptitude à être attachées à la surface de contact, lesdites premières molécules d'interaction étant destinées à interagir par interaction chimique réversible avec une pluralité de deuxièmes molécules d'interaction aptes à être attachées à une surface fonctionnelle dudit au moins un dispositif électronique, ladite interaction chimique étant configurée pour assurer une solidarisation temporaire entre ledit au moins un dispositif électronique et l'organe de manipulation, ladite interaction chimique pouvant en outre être rompue par application d'un traitement chimique et/ou physique à des molécules choisies dans le groupe comprenant la pluralité de premières molécules d'interaction et la pluralité de deuxièmes molécules d'interaction, d'une manière permettant de séparer ledit au moins un dispositif électronique et l'organe de manipulation suite à l'application dudit traitement chimique et/ou physique.

Les dispositions précédemment décrites permettent de proposer un organe de manipulation configuré pour déplacer des dispositifs optoélectroniques par l'intermédiaire des premières et deuxièmes molécules d'interaction. Les dispositifs électroniques peuvent être séparés de l'organe de manipulation lorsqu'ils sont soumis à ce traitement chimique et/ou physique.

Par interaction chimique on entend tout type d'interaction faible ou forte permettant de lier la pluralité de premières molécules d'interaction et la pluralité de deuxièmes molécules d'interaction.

L'organe de manipulation peut en outre présenter une ou plusieurs des caractéristiques suivantes, prises seules ou en combinaison.

Selon un mode de réalisation, le dispositif électronique est un dispositif optoélectronique.

Selon un mode de réalisation, le traitement chimique et/ou physique permettant de séparer ledit au moins un dispositif électronique et l'organe de manipulation comprend l'émission d'un rayonnement lumineux à une première longueur d'onde.

Selon un mode de réalisation, le rayonnement lumineux à la première longueur d'onde est émis par l'organe de manipulation, ou à travers de l'organe de manipulation.

Selon un mode de réalisation, la pluralité de premières molécules d'interaction interagit par liaison covalente avec la pluralité de deuxièmes molécules d'interaction.

Selon un mode de réalisation, la pluralité de premières molécules d'interaction interagit par liaison hydrogène avec la pluralité de deuxièmes molécules d'interaction.

Selon un mode de réalisation, l'interaction chimique est une réaction chimique réversible entre la pluralité de premières molécules d'interaction et la pluralité de deuxièmes molécules d'interaction.

Selon un mode de réalisation, l'interaction chimique est une réaction de Diels-Alder entre la pluralité de premières molécules d'interaction et la pluralité de deuxièmes molécules d'interaction.

Selon un mode de réalisation, l'interaction chimique est une réaction de chimie click entre la pluralité de premières molécules d'interaction et la pluralité de deuxièmes molécules d'interaction.

Selon un mode de réalisation, l'interaction chimique est une réaction de photo addition, ou une réaction de Norrish, ou une réaction de substitution photo dirigée, ou équivalent.

Selon un mode de réalisation, l'interaction chimique est une interaction électrostatique ou une interaction entre espèces aliphatiques.

Selon un mode de réalisation, le dispositif électronique est un dispositif optoélectronique apte à émettre de la lumière à une première longueur d'onde, les premières molécules d'interaction étant configurées pour rompre leur interaction chimique avec les deuxièmes molécules d'interaction lorsque les premières molécules d'interaction sont soumises à un rayonnement lumineux à la première longueur d'onde.

De cette manière, le dispositif électronique et l'organe de manipulation peuvent être séparés lorsque les premières et deuxièmes molécules d'interaction sont éclairées par un rayonnement lumineux, par exemple émis par le dispositif électronique.

Il est donc bien compris qu'un traitement optique, et notamment l'émission d'un rayonnement lumineux à une première longueur d'onde, est un traitement physique.

Selon un mode de réalisation, le dispositif électronique peut comprendre un élément électroluminescent comprenant au moins une diode électroluminescente (LED) apte à émettre et/ou capter de la lumière, et éventuellement un composant électronique de commande associé à ladite au moins une diode électroluminescente, comme par exemple un transistor. En particulier, chaque diode peut comprendre une première partie dopée destinée à être mise en contact avec une première électrode, une deuxième partie dopée destinée à être mise en contact avec une deuxième électrode, et une partie active apte à changer d'état lorsqu'un paramètre externe extérieur à la partie active est appliqué à la partie active, le paramètre externe pouvant par exemple consister à l'application d'un courant. Le composant électronique de commande est notamment apte à influer sur au moins un paramètre externe associé à la partie active. Le composant électronique de commande peut par exemple être apte à moduler au moins un paramètre d'émission relatif au rayonnement lumineux susceptible d'être émis par la partie active.

Selon un mode de réalisation, la première longueur d'onde est comprise entre 400 nm et 800 nm et est notamment sensiblement égale à 420 nm ou sensiblement égale à 450 nm ou sensiblement égale à 470 nm.

Selon un mode de réalisation, les premières molécules d'interaction sont configurées pour interagir par interaction chimique avec les deuxièmes molécules d'interaction lorsque des molécules choisies dans le groupe comprenant la pluralité de premières molécules d'interaction et la pluralité de deuxièmes molécules d'interaction subissent un traitement par rayonnement lumineux à une deuxième longueur d'onde différente de la première longueur d'onde.

Selon un mode de réalisation, la surface de contact du corps présente des plots de contact destinés à être mis en contact avec ledit au moins un dispositif électronique par l'intermédiaire des premières molécules d'interaction.

Selon un mode de réalisation, les plots de contact sont répartis sur la surface de contact selon un écartement prédéterminé correspondant à un écartement entre deux dispositifs optoélectroniques disposés sur un substrat primaire.

Selon un mode de réalisation, l'organe de manipulation comprend au moins une encoche de coopération présentant une forme permettant un emboitement du dispositif électronique, ou présentant une forme complémentaire du dispositif électronique. Dans ce cas, l'organe de manipulation est configuré pour pouvoir s'emboiter avec le dispositif électronique.

Selon un mode de réalisation, l'organe de manipulation comprend une pluralité d'encoches de coopération séparées les unes des autres par l'écartement prédéterminé.

Selon un mode de réalisation, l'écartement prédéterminé est défini comme l'écartement séparant deux dispositifs optoélectroniques sur un substrat secondaire recevant les dispositifs optoélectroniques après une manipulation depuis le substrat primaire au moyen de l'organe de manipulation, notamment un substrat pour un écran d'affichage lumineux. Par exemple, l'écartement prédéterminé peut être compris entre 50 µm et 1 mm, et plus particulièrement sensiblement égal à 100 µm.

Selon un mode réalisation, les premières molécules d'interaction et les deuxièmes molécules d'interaction sont identiques.

Selon un mode de réalisation, les premières molécules d'interaction sont strictement différentes des deuxièmes molécules d'interaction.

Selon un mode de réalisation, au moins une partie des premières molécules d'interaction comprennent chacune un premier site actif, et au moins une partie des deuxièmes molécules d'interaction comprennent un deuxième site actif, lesdits premiers sites actifs étant configurés pour interagir chimiquement avec lesdits deuxièmes sites actifs.

Selon un mode de réalisation, le premier site actif et le deuxième site actif sont identiques.

Selon un autre mode de réalisation, le premier site actif est strictement différent du deuxième site actif.

Selon un mode de réalisation, les premières molécules d'interaction sont configurées pour interagir par interaction chimique avec les deuxièmes molécules d'interaction lorsque des molécules choisies dans le groupe comprenant la pluralité de premières molécules d'interaction et la pluralité de deuxièmes molécules d'interaction subissent un traitement thermique.

Selon un mode de réalisation, les premières molécules d'interaction sont configurées pour interagir par interaction chimique avec les deuxièmes molécules d'interaction lorsque des molécules choisies dans le groupe comprenant la pluralité de premières molécules d'interaction et la pluralité de deuxièmes molécules d'interaction subissent une réaction chimique.

Le but de l'invention peut aussi être atteint grâce à la mise en œuvre d'un procédé de manipulation d'au moins un dispositif électronique à partir d'un substrat primaire.

Le procédé de manipulation comprend :
- - une phase de fourniture d'un système provisoire comprenant un substrat primaire sur lequel est disposé l'au moins un dispositif électronique, et un organe de manipulation, ledit au moins un dispositif électronique présentant une surface fonctionnelle, et ledit organe de manipulation comprenant un corps présentant une surface de contact, l'organe de manipulation comprenant une pluralité de premières molécules d'interaction attachées à la surface de contact, lesdites premières molécules d'interaction étant en situation d'interaction chimique réversible avec une pluralité de deuxièmes molécules d'interaction qui sont attachées au dispositif électronique au niveau de la surface fonctionnelle ;
- une étape de séparation de l'organe de manipulation et de l'au moins un dispositif électronique dans laquelle un traitement physique et/ou chimique est appliqué à des molécules choisies dans le groupe comprenant la pluralité de premières molécules d'interaction et la pluralité de deuxièmes molécules d'interaction de manière à rompre ladite interaction chimique entre la pluralité de premières molécules d'interaction et la pluralité de deuxièmes molécules d'interaction ;
- une étape de retrait de l'organe de manipulation.

Les dispositions précédemment décrites permettent de proposer un procédé de manipulation de dispositifs optoélectroniques par rapport à un substrat primaire. La présence de la pluralité de premières molécules d'interaction et de la pluralité de deuxièmes molécules d'interaction permet à la fois d'attacher l'organe de manipulation avec le dispositif électronique lors de la phase de fourniture d'un système provisoire, et de permettre la séparation du dispositif électronique et de l'organe de manipulation lors de l'étape de séparation.

Par interaction chimique on entend tout type d'interaction faible ou forte permettant de lier la pluralité de premières molécules d'interaction et la pluralité de deuxième molécules d'interaction.

Le procédé de manipulation peut en outre présenter une ou plusieurs des caractéristiques suivantes, prises seules ou en combinaison.

Selon un mode de réalisation, l'organe de manipulation est séparé du substrat primaire lors de l'étape de retrait de l'organe de manipulation.

Selon un mode de réalisation, l'organe de manipulation est séparé d'un substrat secondaire lors de l'étape de retrait de l'organe de manipulation.

Selon un mode de réalisation, l'étape de retrait de l'organe de manipulation est mise en œuvre après l'étape de séparation de l'organe de manipulation et de l'au moins un dispositif électronique.

Selon un mode de réalisation, l'étape de retrait de l'organe de manipulation est mise en œuvre avant l'étape de séparation de l'organe de manipulation et de l'au moins un dispositif électronique.

Selon un mode de réalisation, la phase de fourniture d'un système provisoire comprend :
- une étape de mise à disposition de l'organe de manipulation présentant la surface de contact ;
- une étape de fourniture du substrat primaire sur lequel est disposé l'au moins un dispositif électronique, lequel présente une surface fonctionnelle ;
- une étape de solidarisation temporaire de l'organe de manipulation avec ledit au moins un dispositif électronique, par l'intermédiaire de la pluralité de premières molécules d'interaction et de la pluralité de deuxièmes molécules d'interaction, lesdites premières et deuxièmes molécules d'interaction interagissant entre elles par interaction chimique réversible.

Selon un mode de réalisation, le traitement chimique et/ou physique permettant de rompre l'interaction chimique entre la pluralité de premières molécules d'interaction et la pluralité de deuxièmes molécules d'interaction comprend l'émission d'un rayonnement lumineux à une première longueur d'onde.

Selon un mode de réalisation, le rayonnement lumineux à la première longueur d'onde est émis par l'organe de manipulation, ou à travers de l'organe de manipulation.

Selon un mode de réalisation, ledit au moins un dispositif électronique est un dispositif optoélectronique apte à émettre un rayonnement lumineux à la première longueur d'onde lorsqu'il est alimenté en énergie électrique, l'étape de séparation étant mise en œuvre par l'alimentation du dispositif électronique en énergie électrique.

De cette manière, le dispositif électronique est apte à émettre un rayonnement lumineux à la première longueur d'onde pour réaliser ledit traitement physique et/ou chimique nécessaire à la séparation par rupture de l'interaction chimique.

De manière avantageuse, la pluralité de premières molécules d'interaction et la pluralité de deuxièmes molécules d'interaction sont configurées pour se séparer lorsqu'au moins l'une desdites pluralités est soumise à un rayonnement lumineux à la première longueur d'onde, par exemple si un dispositif électronique est un dispositif optoélectronique apte à émettre de la lumière. De manière synergique, si un dispositif électronique n'émet pas de lumière, par exemple s'il est endommagé, il ne sera pas séparé de l'organe de manipulation. De cette manière, le procédé de manipulation permet de sélectionner un dispositif électronique défectueux à la surface d'un substrat primaire pouvant par exemple être un substrat d'écran.

Selon un mode de réalisation, l'alimentation du dispositif électronique en énergie électrique permet de placer sélectivement le dispositif électronique dans un mode d'émission dans lequel il émet un rayonnement lumineux à la première longueur d'onde, ou dans un mode d'extinction dans lequel il n'émet pas de rayonnement lumineux.

Selon un mode de réalisation, le procédé de manipulation comprend une phase de transfert mise en œuvre après la phase de fourniture d'un système provisoire, la phase de transfert comprenant :
- une étape de détachement dudit au moins un dispositif électronique par rapport au substrat primaire, notamment par traction mécanique appliquée au corps de l'organe de manipulation ; et
- une étape de positionnement dans laquelle la surface de contact de l'organe de manipulation est positionnée en regard d'une surface de réception d'un substrat secondaire.

Selon un mode de réalisation, l'étape de détachement dudit au moins un dispositif électronique par rapport au substrat primaire est réalisée pendant l'étape de retrait de l'organe de manipulation.

Selon un mode de réalisation, lors de l'étape de positionnement, la surface de contact de l'organe de manipulation est positionnée en regard d'une surface de réception d'un substrat secondaire dans une position relative telle que les dispositifs électroniques sont en contact de la surface de réception du substrat secondaire.

Selon un mode de réalisation, la phase de transfert est mise en œuvre avant l'étape de séparation.

Selon un mode de réalisation, la phase de transfert est mise en œuvre après l'étape de séparation.

Selon un mode de réalisation, le substrat primaire comprend une pluralité de dispositifs électroniques répartis sur une surface d'émission du substrat primaire, ladite surface d'émission comprenant des connexions électroniques configurées pour permettre d'alimenter individuellement chaque dispositif électronique de la pluralité de dispositifs électroniques lors d'une étape d'alimentation.

De cette manière, il est possible d'alimenter sélectivement les dispositifs électroniques de manière à réaliser l'étape de séparation de manière sélective au niveau des dispositifs électroniques. En d'autres termes, il est possible de libérer unitairement chaque dispositif électronique du contact avec l'organe de manipulation. Ainsi, les dispositions précédemment décrites permettent de sélectionner unitairement les dispositifs électroniques à manipuler avec l'organe de manipulation. Par exemple, cela peut permettre de retirer uniquement certains dispositifs électroniques prédéterminés depuis la surface du substrat primaire (et pas d'autres), comme par exemple la surface d'émission.

Selon un mode de réalisation, l'étape d'alimentation en énergie électrique est mise en œuvre sélectivement sur au moins un dispositif électronique de la pluralité de dispositifs électroniques.

Par exemple, l'étape d'alimentation en énergie électrique peut être mise en œuvre sur des dispositifs électroniques séparés deux à deux par une distance prédéterminée, notamment comprise entre 50 µm et 1 mm.

Selon un mode de réalisation, le procédé de manipulation comprend une étape de fonctionnalisation de la surface de contact de l'organe de manipulation mise en œuvre avant la phase de fourniture d'un système provisoire, dans laquelle la surface de contact est fonctionnalisée de manière à permettre aux premières molécules d'interaction d'être attachées à la surface de contact.

Selon un mode de réalisation, l'étape de fonctionnalisation de la surface de contact comprend l'exposition de la surface de contact à un plasma comprenant du dioxygène pour générer une pluralité de liaisons hydroxyles.

Selon un mode de réalisation, le procédé de manipulation comprend une étape de fonctionnalisation de la surface fonctionnelle du dispositif électronique mise en œuvre avant la phase de fourniture d'un système provisoire, dans laquelle la surface fonctionnelle est fonctionnalisée de manière à permettre aux deuxièmes molécules d'interaction d'être attachées à la surface fonctionnelle.

Selon un mode de réalisation, l'étape de fonctionnalisation de la surface fonctionnelle comprend l'exposition de la surface fonctionnelle à un plasma comprenant du dioxygène pour générer une pluralité de liaisons hydroxyles.

Selon un mode de réalisation, le procédé comprend une étape d'activation, dans laquelle au moins l'une parmi la surface de contact et la surface fonctionnelle est soumise à un traitement d'activation physique ou chimique de manière à activer des groupements chimiques réactifs sur la pluralité de premières molécules d'interaction et/ou sur la pluralité de deuxièmes molécules d'interaction.

Selon un mode de réalisation, l'étape d'activation comprend un traitement par rayonnement lumineux à une deuxième longueur d'onde différente de la première longueur d'onde.

Selon un mode de réalisation, l'étape de solidarisation temporaire est mise en œuvre par une réaction chimique réversible entre la pluralité de premières molécules d'interaction et la pluralité de deuxièmes molécules d'interaction.

Selon un mode de réalisation, l'étape de solidarisation temporaire est mise en œuvre par une réaction de Diels-Alder entre la pluralité de premières molécules d'interaction et la pluralité de deuxièmes molécules d'interaction.

Selon un mode de réalisation, l'étape de solidarisation temporaire est mise en œuvre par une réaction de chimie click entre la pluralité de premières molécules d'interaction et la pluralité de deuxièmes molécules d'interaction.

Selon un mode de réalisation, l'étape de solidarisation temporaire est mise en œuvre par une réaction de photo addition, ou une réaction de Norrish, ou une réaction de substitution photo dirigée, ou équivalent.

Selon un mode de réalisation, les premières molécules d'interaction et/ou les deuxièmes molécules d'interaction comprennent au moins une chaîne carbonée.

Selon un mode de réalisation, ladite au moins une chaine carbonée présente une extrémité distale au niveau de laquelle est disposé un site actif distal configuré pour permettre l'interaction chimique réversible entre les premières molécules d'interaction et les deuxièmes molécules d'interaction.

Selon un mode de réalisation, ladite au moins une chaine carbonée présente une extrémité proximale au niveau de laquelle est disposé un site actif proximal configuré pour permettre à ladite au moins une chaîne carbonée d'être attachée à la surface fonctionnelle ou à la surface de contact.

De manière avantageuse, la présence de chaînes carbonées dans les premières molécules d'interaction et les deuxièmes molécules d'interaction favorise l'interaction des sites actifs distaux présents aux extrémités de chaque chaîne carbonée.

### Description sommaire des dessins

D'autres aspects, buts, avantages et caractéristiques de l'invention apparaîtront mieux à la lecture de la description détaillée suivante de modes de réalisation préférés de celle-ci, donnée à titre d'exemple non limitatif, et faite en référence aux dessins annexés sur lesquels :
[Fig. 1] La figure 1 est une vue schématique de certaines étapes du procédé de manipulation selon un mode de réalisation particulier de l'invention.
[Fig. 2] La figure 2 est une vue schématique de certaines étapes du procédé de manipulation selon un mode de réalisation particulier de l'invention.
[Fig. 3] La figure 3 est une vue schématique de l'étape de solidarisation temporaire du procédé de manipulation selon un mode de réalisation particulier de l'invention.
[Fig. 4] La figure 4 est une vue schématique de certaines étapes du procédé de manipulation selon un mode de réalisation particulier de l'invention.
[Fig. 5] La figure 5 est une vue schématique certaines étapes du procédé de manipulation selon un mode de réalisation particulier de l'invention.
[Fig. 6] La figure 6 est une vue schématique de certaines étapes du procédé de manipulation selon un mode de réalisation particulier de l'invention.
[Fig. 7] La figure 7 est une vue schématique d'un type particulier de première molécule d'interaction ou de deuxième molécule d'interaction.

### Description détaillée

Sur les figures et dans la suite de la description, les mêmes références représentent les éléments identiques ou similaires. De plus, les différents éléments ne sont pas représentés à l'échelle de manière à privilégier la clarté des figures. Par ailleurs, les différents modes de réalisation et variantes ne sont pas exclusifs les uns des autres et peuvent être combinés entre eux.

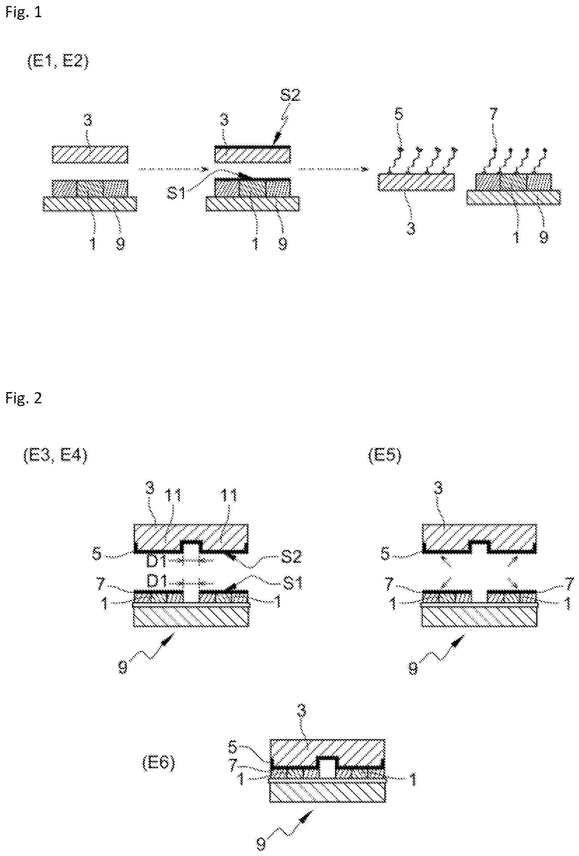

Comme illustré sur les figures 1 à 6, l'invention concerne d'abord un organe de manipulation 3 apte à manipuler au moins un dispositif électronique 1, et également un procédé de manipulation d'un tel dispositif électronique 1 à partir d'un substrat primaire 9. De manière générale, le dispositif électronique 1 est un dispositif optoélectronique destiné à être fixé sur une face de réception d'un substrat secondaire 19, comme par exemple un substrat pour un écran d'affichage lumineux, notamment moyennant une répartition surfacique d'une pluralité de tels dispositifs optoélectroniques 1 sur tout ou partie de la surface libre de la face de réception.

Selon un mode de réalisation, chaque dispositif optoélectronique peut comprendre un élément électroluminescent comprenant au moins une diode électroluminescente (LED) apte à émettre et/ou capter de la lumière, et éventuellement un composant électronique de commande associé à ladite au moins une diode électroluminescente, comme par exemple un transistor. En particulier, chaque diode peut comprendre une première partie dopée destinée à être mise en contact avec une première électrode, une deuxième partie dopée destinée à être mise en contact avec une deuxième électrode, et une partie active apte à changer d'état lorsqu'un paramètre externe extérieur à la partie active est appliqué à la partie active, le paramètre externe pouvant par exemple consister à l'application d'un courant. Le composant électronique de commande est notamment apte à influer sur au moins un paramètre externe associé à la partie active. Le composant électronique de commande peut par exemple être apte à moduler au moins un paramètre d'émission relatif au rayonnement lumineux susceptible d'être émis par la partie active.

En référence à la figure 1, l'organe de manipulation 3 comprend un corps présentant une surface de contact S2. L'organe de manipulation comprend en outre une pluralité de premières molécules d'interaction 5 ayant une aptitude à être attachées à la surface de contact S2. Le dispositif électronique 1 présente une surface fonctionnelle S1 sur laquelle une pluralité de deuxièmes molécules d'interaction 7 sont aptes à être attachées.

Comme illustré sur la figure 2, la surface de contact S2 du corps peut présenter des plots de contact 11 destinés à être mis en contact avec ledit au moins un dispositif électronique 1 par l'intermédiaire des premières molécules d'interaction 5. Les plots de contact 11 peuvent être répartis sur la surface de contact S2 selon un écartement prédéterminé D1 correspondant à un écartement entre deux dispositifs optoélectroniques 1 disposés sur un substrat primaire 9.

Selon un autre mode de réalisation non représenté, l'organe de manipulation 3 comprend au moins une encoche de coopération présentant une forme permettant un emboitement du dispositif électronique 1, ou présentant une forme complémentaire du dispositif électronique 1. Dans ce cas, l'organe de manipulation 3 est configuré pour pouvoir s'emboiter avec le dispositif électronique 1.

De manière avantageuse, l'écartement prédéterminé D1 peut être défini comme l'écartement séparant deux dispositifs électroniques 1 sur un substrat secondaire 19 recevant les dispositifs électroniques 1 après une manipulation depuis le substrat primaire 9 au moyen de l'organe de manipulation 3, notamment un substrat pour un écran d'affichage lumineux. Par exemple, l'écartement prédéterminé D1 peut être compris entre 50 µm et 1 mm, et plus particulièrement sensiblement égal à 100 µm.

Les premières molécules d'interaction 5 sont destinées à interagir par interaction chimique réversible avec la pluralité de deuxièmes molécules d'interaction 7. L'interaction chimique est configurée pour assurer une solidarisation temporaire entre ledit au moins un dispositif électronique 1 et l'organe de manipulation 3. L'interaction chimique peut notamment être une réaction chimique réversible entre la pluralité de premières molécules d'interaction 5 et la pluralité de deuxièmes molécules d'interaction 7.

Par exemple, les premières molécules d'interaction 5 sont configurées pour interagir par interaction chimique avec les deuxièmes molécules d'interaction 7 lorsque des molécules choisies dans le groupe comprenant la pluralité de premières molécules d'interaction 5 et la pluralité de deuxièmes molécules d'interaction 7 subissent un traitement thermique ou lorsqu'elles subissent une réaction chimique.

Selon un premier mode de réalisation, la pluralité de premières molécules d'interaction 5 interagit par liaison covalente avec la pluralité de deuxièmes molécules d'interaction 7. Selon un deuxième mode de réalisation, la pluralité de premières molécules d'interaction 5 interagit par liaison hydrogène avec la pluralité de deuxièmes molécules d'interaction 7. Selon un troisième mode de réalisation, l'interaction chimique est une réaction de Diels-Alder entre la pluralité de premières molécules d'interaction 5 et la pluralité de deuxièmes molécules d'interaction 7. Selon quatrième mode de réalisation, l'interaction chimique est une réaction de chimie click entre la pluralité de premières molécules d'interaction 5 et la pluralité de deuxièmes molécules d'interaction 7. Selon un cinquième mode de réalisation, l'interaction chimique est une réaction de photo addition, ou une réaction de Norrish, ou une réaction de substitution photo dirigée, ou équivalent. Selon sixième mode de réalisation, l'interaction chimique est une interaction électrostatique ou une interaction entre espèces aliphatiques.

Selon un mode réalisation, les premières molécules d'interaction 5 et les deuxièmes molécules d'interaction 7 sont identiques. Alternativement, les premières molécules d'interaction 5 sont strictement différentes des deuxièmes molécules d'interaction 7.

Selon un mode de réalisation, au moins une partie des premières molécules d'interaction 5 comprennent chacune un premier site actif, et au moins une partie des deuxièmes molécules d'interaction 7 comprennent un deuxième site actif, lesdits premiers sites actifs étant configurés pour interagir chimiquement avec lesdits deuxièmes sites actifs.

Selon un mode de réalisation, le premier site actif et le deuxième site actif sont identiques.

Selon un autre mode de réalisation, le premier site actif est strictement différent du deuxième site actif.

Par ailleurs, l'interaction chimique joignant les premières molécules d'interaction 5 avec lesdites deuxièmes molécules d'interaction 7 est susceptible d'être rompue par application d'un traitement chimique et/ou physique. Le traitement physique et/ou chimique est appliqué à des molécules choisies dans le groupe comprenant la pluralité de premières molécules d'interaction 5 et la pluralité de deuxièmes molécules d'interaction 7, d'une manière permettant de séparer ledit au moins un dispositif électronique 1 et l'organe de manipulation 3 suite à l'application dudit traitement chimique et/ou physique. Selon un mode de réalisation, le traitement chimique et/ou physique permettant de séparer ledit au moins un dispositif électronique 1 et l'organe de manipulation 3 comprend l'émission d'un rayonnement lumineux à une première longueur d'onde. Par exemple, le rayonnement lumineux à la première longueur d'onde peut être émis par l'organe de manipulation 3, ou à travers de l'organe de manipulation 3.

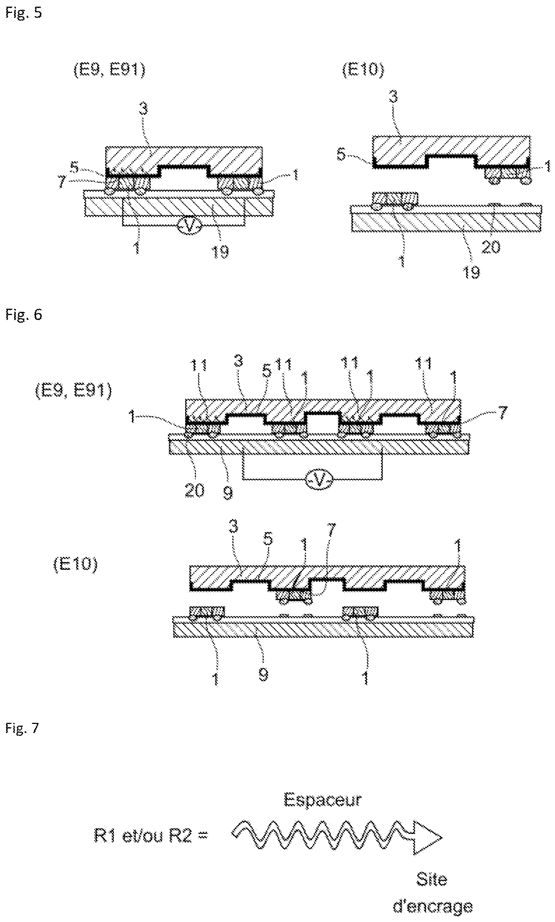

Selon une variante non limitative représentée sur les figures 5 et 6, le dispositif électronique 1 est un dispositif optoélectronique apte à émettre de la lumière à la première longueur d'onde. La première longueur d'onde peut notamment être comprise entre 400 nm et 800 nm et être notamment sensiblement égale à 420 nm ou sensiblement égale à 450 nm ou sensiblement égale à 470 nm.

Dans ce cas, les premières molécules d'interaction 5 peuvent être configurées pour rompre leur interaction chimique avec les deuxièmes molécules d'interaction 7 du dispositif électronique 1 lorsque les premières molécules d'interaction 5 sont soumises à un rayonnement lumineux à la première longueur d'onde. De cette manière, le dispositif électronique 1 et l'organe de manipulation 3 peuvent être séparés lorsque les premières et deuxièmes molécules d'interaction 5, 7 sont éclairées par un rayonnement lumineux, par exemple émis par le dispositif électronique 1.

De manière avantageuse, les premières molécules d'interaction 5 peuvent être configurées pour interagir par interaction chimique avec les deuxièmes molécules d'interaction 7 lorsque des molécules choisies dans le groupe comprenant la pluralité de premières molécules d'interaction 5 et la pluralité de deuxièmes molécules d'interaction 7 subissent un traitement par rayonnement lumineux à une deuxième longueur d'onde différente de la première longueur d'onde.

De cette manière, les premières molécules d'interaction 5 peuvent se solidariser temporairement avec les deuxièmes molécules d'interaction 7 lorsqu'elles subissent un traitement par rayonnement lumineux à la deuxième longueur d'onde et se séparer des deuxièmes molécules d'interaction 7 lorsqu'elles subissent un traitement par rayonnement lumineux à la première longueur d'onde. En d'autres termes, l'organe de manipulation 3 et le dispositif électronique 1 peuvent être attachés et détachés de manière réversible selon leur exposition à la première longueur d'onde ou à la deuxième longueur d'onde.

Les dispositions précédemment décrites permettent de proposer un organe de manipulation 3 configuré pour déplacer des dispositifs optoélectroniques 1 par l'intermédiaire des premières et deuxièmes molécules d'interaction 5, 7. Les dispositifs optoélectroniques 1 peuvent être séparés de l'organe de manipulation 3 lorsqu'ils sont soumis à un traitement chimique et/ou physique. Cela peut permettre une sélection des dispositifs optoélectroniques transférés par l'organe de manipulation ou des dispositifs optoélectroniques qui seraient défectueux.

Comme indiqué précédemment, l'invention concerne également un procédé de manipulation d'au moins un dispositif électronique 1 à partir d'un substrat primaire 9. Le dispositif électronique 1 peut notamment être un dispositif optoélectronique apte à émettre un rayonnement lumineux à une première longueur d'onde lorsqu'il est alimenté en énergie électrique. Les figures 1 et 2 illustrent certaines étapes d'un mode de réalisation particulier et non limitatif du procédé de manipulation. Le procédé de manipulation comprend une phase de fourniture d'un système provisoire comprenant un organe de manipulation 3, et un substrat primaire 9 sur lequel est disposé l'au moins un dispositif électronique 1. Ledit au moins un dispositif électronique 1 présente une surface fonctionnelle S1, et ledit organe de manipulation 3 comprend un corps présentant une surface de contact S2. L'organe de manipulation comprend au niveau de la surface de contact S2, une pluralité de premières molécules d'interaction 5 en situation d'interaction chimique réversible avec une pluralité de deuxièmes molécules d'interaction 7 qui sont attachées au dispositif électronique 1 au niveau de la surface fonctionnelle S1. Selon un mode de réalisation, la phase de fourniture d'un système provisoire comprend une étape E3 de mise à disposition d'un organe de manipulation 3, par exemple du type d'un de ceux décrits précédemment, présentant la surface de contact S2. Cette surface de contact S2 peut comprendre la pluralité de premières molécules d'interaction 5. La figure 1 présente notamment une étape E1 de fonctionnalisation de la surface de contact S2 de l'organe de manipulation 3 mise en œuvre avant une étape E3 de mise à disposition de l'organe de manipulation 3. Lors de cette étape E1, la surface de contact S2 est fonctionnalisée de manière à permettre aux premières molécules d'interaction 5 d'être attachées à la surface de contact S2. Par exemple, l'étape E1 de fonctionnalisation de la surface de contact S2 peut comprendre l'exposition de la surface de contact S2 à un plasma comprenant du dioxygène pour générer une pluralité de groupements hydroxyles. Selon une autre variante, l'étape E1 de fonctionnalisation de la surface de contact S2 comprend la fonctionnalisation par des fonctions d'accroche de type amines ou silanes, ou équivalent.

Par ailleurs, la phase de fourniture d'un système provisoire peut comprendre une étape E4 de fourniture du substrat primaire 9 sur lequel est disposé l'au moins un dispositif électronique 1, lequel présente la surface fonctionnelle S1 sur laquelle peut être attachée la pluralité de deuxièmes molécules d'interaction 7. La figure 1 présente également une étape E2 de fonctionnalisation de la surface fonctionnelle S1 du dispositif électronique 1 mise en œuvre avant l'étape E4 de fourniture du substrat primaire 9. Lors de cette étape E2, la pluralité de deuxièmes molécules d'interaction 7 est disposée sur la surface fonctionnelle S1. Par exemple, l'étape E2 de fonctionnalisation de la surface fonctionnelle S1 peut comprendre l'exposition de la surface fonctionnelle S1 à un plasma comprenant du dioxygène pour générer une pluralité de groupements hydroxyles. Alternativement, l'étape E2 de fonctionnalisation de la surface fonctionnelle S1 peut comprendre la fonctionnalisation par des fonctions d'accroche de type amines ou silanes, ou équivalent.

Le procédé de manipulation peut également comprendre une étape E5 d'activation, dans laquelle au moins l'une parmi la surface de contact S2 et la surface fonctionnelle S1 est soumise à un traitement d'activation physique ou chimique de manière à activer des groupements chimiques réactifs sur la pluralité de premières molécules d'interaction 5 et/ou sur la pluralité de deuxièmes molécules d'interaction 7. Par exemple, l'étape E5 d'activation peut comprendre un traitement par rayonnement lumineux à une deuxième longueur d'onde différente de la première longueur d'onde.

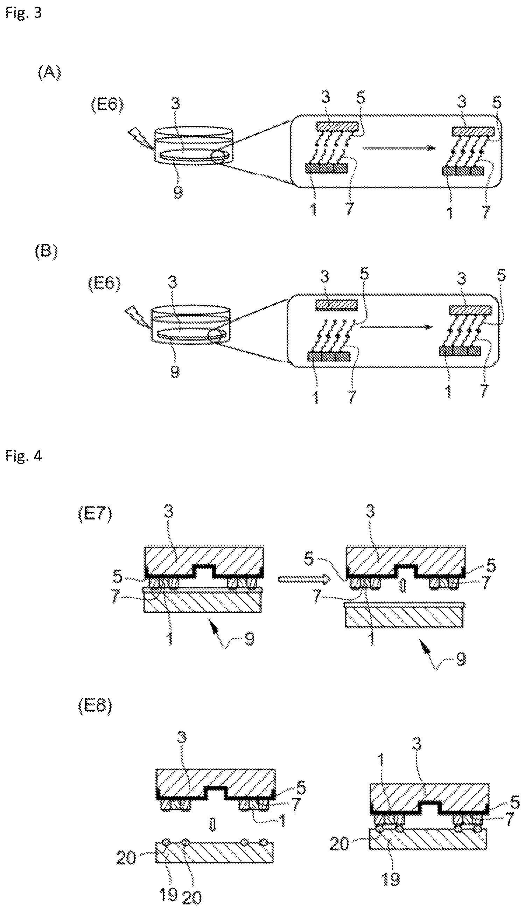

En référence à la figure 3, la phase de fourniture d'un système provisoire peut comprendre une étape E6 de solidarisation temporaire de l'organe de manipulation 3 avec ledit au moins un dispositif électronique 1, par l'intermédiaire de la pluralité de premières molécules d'interaction 5 et de la pluralité de deuxièmes molécules d'interaction 7, lesdites premières et deuxièmes molécules d'interaction 5, 7 interagissant entre elles par interaction chimique réversible. En d'autres termes, l'étape E6 de solidarisation temporaire peut être mise en œuvre par une réaction chimique réversible entre la pluralité de premières molécules d'interaction 5 et la pluralité de deuxièmes molécules d'interaction 7. Comme illustré sur la figure 3A, les premières molécules d'interaction 5 peuvent être attachées sur la surface de contact S2 de l'organe de manipulation 3, et les deuxièmes molécules d'interaction 7 peuvent être attachées à la surface fonctionnelle S1 du dispositif électronique 1. Dans ce cas, l'étape E6 de solidarisation temporaire est mise en œuvre en faisant interagir entre elles, par interaction chimique réversible, les premières et deuxièmes molécules d'interaction 5,7.

Alternativement, et comme représenté sur la figure 3B, les premières et deuxièmes molécules d'interaction 5, 7 peuvent être en situation d'interaction chimique réversible entre elles, et les deuxièmes molécules d'interaction 7 peuvent être attachées à la surface fonctionnelle S1 du dispositif électronique 1. Dans ce cas, l'étape E6 de solidarisation temporaire est mise en œuvre par attachement des premières molécules d'interaction 5 au niveau de la surface de contact S2 de l'organe de manipulation 3.

Enfin, selon un troisième mode de réalisation non représenté, les premières et deuxièmes molécules d'interaction 5, 7 peuvent être en situation d'interaction chimique réversible entre elles, et les premières molécules d'interaction 5 peuvent être attachées à la surface de contact S2 de l'organe de manipulation 3. Dans ce cas, l'étape E6 de solidarisation temporaire est mise en œuvre par attachement des deuxièmes molécules d'interaction 7 au niveau de la surface fonctionnelle S1 du dispositif électronique.

Après l'étape E6 de solidarisation temporaire de l'organe de manipulation 3 avec le dispositif électronique 1, le procédé de manipulation peut comprendre une phase de transfert illustrée sur la figure 4.

Cette phase de transfert comprend une étape E7 de détachement dudit au moins un dispositif électronique 1 par rapport au substrat primaire 9, notamment par traction mécanique appliquée au corps de l'organe de manipulation 3, et une étape E8 de positionnement dans laquelle la surface de contact S2 de l'organe de manipulation 3 est positionnée en regard d'une surface de réception d'un substrat secondaire 19, par exemple dans une position relative telle que les dispositifs optoélectroniques 1 sont en contact de la surface de réception du substrat secondaire 19.

Comme illustré sur les figures 5 et 6, le procédé de manipulation peut comprendre en outre une étape E9 de séparation de l'organe de manipulation 3 et de l'au moins un dispositif électronique 1, mise en œuvre avant ou après la phase de transfert, dans laquelle un traitement physique et/ou chimique est appliqué à des molécules choisies dans le groupe comprenant la pluralité de premières molécules d'interaction 5 et la pluralité de deuxièmes molécules d'interaction 7. Ce traitement physique et/ou chimique est appliqué de manière à rompre ladite interaction chimique entre la pluralité de premières molécules d'interaction 5 et la pluralité de deuxièmes molécules d'interaction 7. Par exemple, le traitement chimique et/ou physique permettant de rompre l'interaction chimique entre la pluralité de premières molécules d'interaction 5 et la pluralité de deuxièmes molécules d'interaction 7 comprend l'émission d'un rayonnement lumineux à une première longueur d'onde. Selon une première variante, le rayonnement lumineux à la première longueur d'onde est émis par l'organe de manipulation 3, ou à travers de l'organe de manipulation 3.

Selon une autre variante dans laquelle le dispositif électronique 1 est un dispositif optoélectronique apte à émettre un rayonnement lumineux à une première longueur d'onde lorsqu'il est alimenté en énergie électrique, l'étape E9 de séparation peut être mise en œuvre lorsque le dispositif électronique 1 est alimenté en énergie électrique. De cette manière, le dispositif électronique 1 est apte à émettre un rayonnement lumineux à la première longueur d'onde pour réaliser ledit traitement physique et/ou chimique nécessaire à la séparation par rupture de l'interaction chimique. Il est donc bien compris que selon ce mode de réalisation, la pluralité de premières molécules d'interaction 5 et la pluralité de deuxièmes molécules d'interaction 7 sont configurées pour se séparer lorsqu'au moins l'une desdites pluralités est soumise à un rayonnement lumineux à la première longueur d'onde, c'est-à-dire notamment lorsque le dispositif électronique 1 émet de la lumière. De manière synergique, si un dispositif optoélectronique n'émet pas de lumière, par exemple s'il est endommagé, il ne sera pas séparé de l'organe de manipulation 3. De cette manière, le procédé de manipulation permet de sélectionner un dispositif optoélectronique défectueux à la surface d'un substrat primaire 9 pouvant par exemple être un substrat d'écran.

Selon le mode de réalisation présenté sur les figures 5 et 6, l'alimentation du dispositif optoélectronique 1 en énergie électrique permet de placer sélectivement le dispositif optoélectronique 1 dans un mode d'émission dans lequel il émet un rayonnement lumineux à la première longueur d'onde, ou dans un mode d'extinction dans lequel il n'émet pas le rayonnement lumineux à la première longueur d'onde.

Les figures 5 et 6 présentent des modes de réalisation dans lesquels le substrat primaire 9, ou le substrat secondaire 19 comprennent une pluralité de dispositifs électroniques 1 répartis sur une surface d'émission du substrat primaire 9 ou du substrat secondaire 19. La surface d'émission comprend notamment des connexions électroniques 20 configurées pour permettre d'alimenter individuellement chaque dispositif électronique 1 de la pluralité de dispositifs électroniques 1 lors d'une étape d'alimentation E91. L'étape E91 d'alimentation en énergie électrique peut donc être mise en œuvre sélectivement sur au moins un dispositif électronique 1 de la pluralité de dispositifs électroniques 1. Par exemple, l'étape E91 d'alimentation en énergie électrique peut être mise en œuvre sur des dispositifs électroniques 1 séparés deux à deux par une distance prédéterminée, notamment comprise entre 50 µm et 1 mm.

De cette manière, il est possible d'alimenter sélectivement les dispositifs électroniques 1 de manière à réaliser l'étape E9 de séparation de manière sélective au niveau des dispositifs électroniques 1. En d'autres termes, il est possible de libérer unitairement chaque dispositif électronique 1 du contact avec l'organe de manipulation 3. Ainsi, les dispositions précédemment décrites permettent de sélectionner unitairement les dispositifs électroniques 1 à manipuler avec l'organe de manipulation 3. Par exemple, cela peut permettre de retirer uniquement certains dispositifs électroniques 1 prédéterminés depuis la surface du substrat primaire 9 ou du substrat secondaire 19 (et pas d'autres), comme par exemple la surface d'émission.

Enfin, le procédé de manipulation comprend une étape E10 de retrait de l'organe de manipulation 3. Par exemple, lors de l'étape de retrait E10, l'organe de manipulation 3 est séparé du substrat primaire 9. Alternativement, l'organe de manipulation 3 peut être séparé d'un substrat secondaire 19 lors de l'étape E10 de retrait de l'organe de manipulation 3.

Selon un mode de réalisation, l'étape E10 de retrait de l'organe de manipulation 3 est mise en œuvre après l'étape E9 de séparation de l'organe de manipulation 3 et de l'au moins un dispositif électronique 1.

Selon un autre mode de réalisation, l'étape E10 de retrait de l'organe de manipulation 3 est mise en œuvre avant l'étape E9 de séparation de l'organe de manipulation 3 et de l'au moins un dispositif électronique 1. Par exemple l'étape E10 de retrait de l'organe de manipulation 3 est réalisée pendant l'étape E7 de détachement dudit au moins un dispositif électronique 1 par rapport au substrat primaire 9.

Les dispositions précédemment décrites permettent de proposer un procédé de manipulation de dispositifs optoélectroniques 1 par rapport à un substrat primaire 9. La présence de la pluralité de premières molécules d'interaction 5 et de la pluralité de deuxièmes molécules d'interaction 7 permet à la fois d'attacher l'organe de manipulation 3 avec le dispositif électronique 1 lors de l'étape E6 de solidarisation temporaire, et de permettre la séparation du dispositif électronique 1 et de l'organe de manipulation 3 lors de l'étape E9 de séparation.

Il est décrit ci-après des modes de réalisation particuliers permettant d'implémenter les principes généraux évoqués précédemment.

Selon une première variante non limitative, l'étape E6 de solidarisation temporaire est mise en œuvre par une réaction de Diels-Alder entre la pluralité de premières molécules d'interaction 5 et la pluralité de deuxièmes molécules d'interaction 7. Par réaction de Diels-Alder, on entend une réaction chimique dans laquelle un alcène s'additionne à un diène conjugué pour former un dérivé du cyclohexène. A titre de premier exemple la réaction de Diels-Alder peut être mise en œuvre par la mise en réaction d'un composé de formule C1, avec un composé de formule C2, où R, R1 et R2 représentent des groupements chimiques différents entre eux ou non.

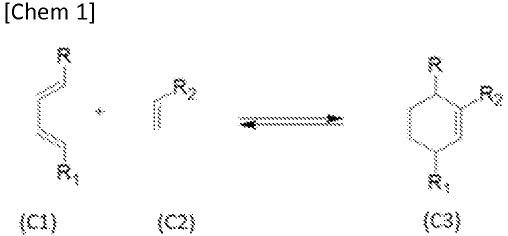

Par exemple les groupements R, R1, et R2 présentés ici et dans la suite de la description peuvent correspondre à des groupements présentant des fonctions hydrophiles (comme des chaines alcoolates, des éthylènes glycols, des acrylates, etc.) permettant de faciliter la mise en œuvre du procédé dans des solvants aqueux. Les groupements R, R1, et R2 peuvent également correspondre à des groupes apolaires (chaines alkyles ou alcènes conjuguées), permettant d'organiser les réactifs avant un éventuel traitement optique. Enfin, les groupements R, R1, et R2 peuvent comprendre des chaînes carbonées ou oxygénées (alkyls, des alcènes ou des éthylènes glycol) présentant une longueur de chaine carbonées supérieure à trois atomes de carbone, et par exemple inférieure à 20 atomes de carbone. Par exemple ces chaines carbonées ou oxygénées peuvent comprendre des petits oligomères (ayant de 3 à 10 monomères), ou des chaines peptidiques. De manière avantageuse, ces chaines carbonées ou oxygénées permettent d'apporter une plus grande flexibilité aux premières molécules d'interaction 5 ou aux deuxièmes molécules d'interaction 7, comme illustré sur la figure 7.

En d'autres termes, les premières molécules d'interaction 5 et/ou les deuxièmes molécules d'interaction 7 peuvent comprendre au moins une chaîne carbonée. Ladite au moins une chaine carbonée peut présenter une extrémité distale au niveau de laquelle est disposé un site actif distal configuré pour permettre l'interaction chimique réversible entre les premières molécules d'interaction 5 et les deuxièmes molécules d'interaction 7. Par ailleurs, ladite au moins une chaine carbonée peut présenter une extrémité proximale au niveau de laquelle est disposé un site actif proximal configuré pour permettre à ladite au moins une chaîne carbonée d'être attachée à la surface fonctionnelle S1 ou à la surface de contact S2.

Dans le cas décrit ci avant, l'étape E6 de solidarisation temporaire est réalisée par traitement thermique à une première température de manière à former un composé de formule C3, et l'étape E9 de séparation est réalisée par traitement thermique à une deuxième température différente de la première température.

Selon un deuxième exemple, la réaction de Diels-Alder peut être mise en œuvre par la mise en réaction d'un composé de formule C4, avec un composé de formule C5, où R1 et R2 représentent des groupements chimiques différents entre eux ou non.

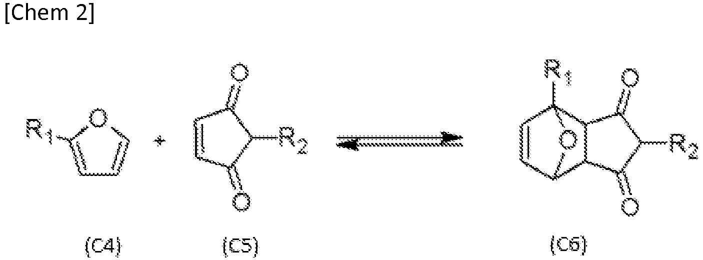

Dans ce cas, l'étape E6 de solidarisation temporaire peut être réalisée par traitement thermique à une température comprise entre 25°C et 120°C de manière à former un composé de formule C6, et l'étape E9 de séparation est réalisée par traitement thermique à une température strictement supérieure à 120°C.

Selon une deuxième variante non limitative, l'étape E6 de solidarisation temporaire est mise en œuvre par une réaction de chimie click entre la pluralité de premières molécules d'interaction 5 et la pluralité de deuxièmes molécules d'interaction 7. A titre de troisième exemple la réaction de chimie clic peut être mise en œuvre par la mise en réaction d'un composé de formule C7, avec un composé de formule C8, où R1 et R2 représentent des groupements chimiques différents entre eux ou non.

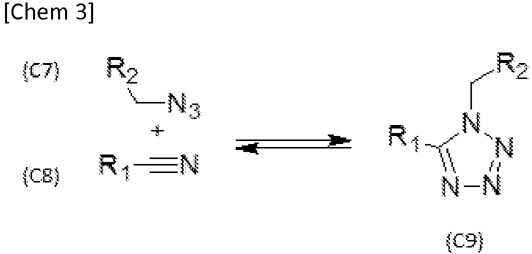

Dans cet exemple, l'étape E6 de solidarisation temporaire est réalisée par réaction catalytique en présence de cuivre ou d'un complexe organométallique de cuivre, de manière à former un groupe clivable de formule C9, et l'étape E9 de séparation est réalisée par rayonnement lumineux à une première longueur d'onde. De manière avantageuse, la première longueur d'onde peut être choisie en fonction des groupements chimiques présents dans les premières molécules d'interaction 5 ou dans les deuxièmes molécules d'interaction 7.

En particulier, la première longueur d'onde peut être sensiblement égale à 302nm lorsque le groupe clivable C9 correspond à la formule suivante :

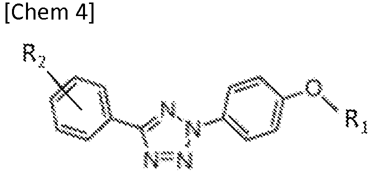

Alternativement, la première longueur d'onde peut être sensiblement égale à 365nm lorsque le groupe clivable C9 correspond à la formule suivante :

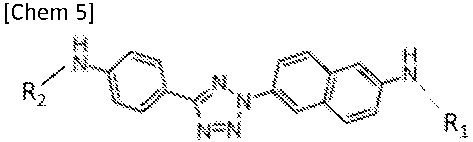

Alternativement, la première longueur d'onde peut être sensiblement égale à 405nm lorsque le groupe clivable C9 correspond à la formule suivante :

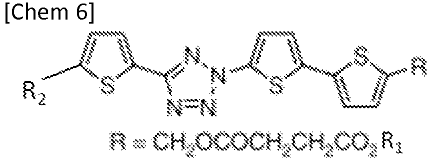

Alternativement, la première longueur d'onde peut être sensiblement égale à 700nm lorsque le groupe clivable C9 correspond à la formule suivante :

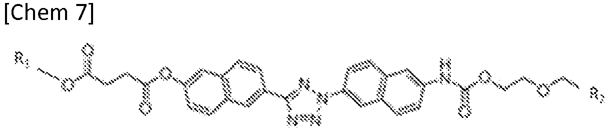

A titre de quatrième exemple, la réaction de chimie click peut être mise en œuvre par la mise en réaction d'un composé de formule C10, avec un composé de formule C11, où R1 et R2 représentent des groupements chimiques différents entre eux ou non.

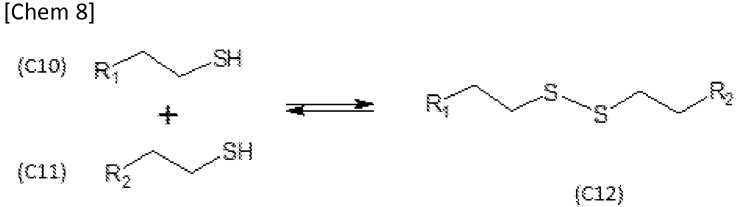

Dans cet exemple, l'étape E6 de solidarisation temporaire est réalisée par réaction chimique, de manière à former un composé de formule C12, et l'étape E9 de séparation est réalisée par rayonnement lumineux à une première longueur d'onde, par exemple comprise entre 300 nm et 450 nm.

## Revendications

1. Organe de manipulation (3) apte à manipuler au moins un dispositif électronique (1), ledit organe de manipulation (3) comprenant un corps présentant une surface de contact (S2), ledit organe de manipulation (3) comprenant en outre une pluralité de premières molécules d'interaction (5) ayant une aptitude à être attachées à la surface de contact (S2), lesdites premières molécules d'interaction (5) étant destinées à interagir par interaction chimique réversible avec une pluralité de deuxièmes molécules d'interaction (7) aptes à être attachées à une surface fonctionnelle (S1) dudit au moins un dispositif électronique (1), ladite interaction chimique étant configurée pour assurer une solidarisation temporaire entre ledit au moins un dispositif électronique (1) et l'organe de manipulation (3), ladite interaction chimique étant susceptible d'être rompue par application d'un traitement chimique et/ou physique à des molécules choisies dans le groupe comprenant la pluralité de premières molécules d'interaction (5) et la pluralité de deuxièmes molécules d'interaction (7), d'une manière permettant de séparer ledit au moins un dispositif électronique (1) et l'organe de manipulation (3) suite à l'application dudit traitement chimique et/ou physique.

2. Organe de manipulation (3) selon la revendication 1, dans lequel le traitement chimique et/ou physique permettant de séparer ledit au moins un dispositif électronique (1) et l'organe de manipulation (3) comprend l'émission d'un rayonnement lumineux à une première longueur d'onde.

3. Organe de manipulation (3) selon la revendication 2, dans lequel le rayonnement lumineux à la première longueur d'onde est émis par l'organe de manipulation (3), ou à travers de l'organe de manipulation (3).

4. Organe de manipulation (3) selon l'une des revendications 2 ou 3, dans lequel les premières molécules d'interaction (5) sont configurées pour interagir par interaction chimique avec les deuxièmes molécules d'interaction (7) lorsque des molécules choisies dans le groupe comprenant la pluralité de premières molécules d'interaction (5) et la pluralité de deuxièmes molécules d'interaction (7) subissent un traitement par rayonnement lumineux à une deuxième longueur d'onde différente de la première longueur d'onde.

5. Organe de manipulation (3) selon l'une quelconque des revendications 2 à 4, dans lequel le dispositif électronique (1) est un dispositif optoélectronique apte à émettre de la lumière à la première longueur d'onde, les premières molécules d'interaction (5) étant configurées pour rompre leur interaction chimique avec les deuxièmes molécules d'interaction (7) lorsque les premières molécules d'interaction (5) sont soumises à un rayonnement lumineux à la première longueur d'onde.

6. Organe de manipulation (3) l'une quelconque des revendications 2 à 5, dans lequel la première longueur d'onde est comprise entre 400 nm et 800 nm et est notamment sensiblement égale à 420nm, ou sensiblement égale à 450 nm, ou sensiblement égale à 470 nm.

7. Organe de manipulation (3) selon l'une quelconque des revendications 1 à 6, dans lequel la surface de contact (S2) du corps présente des plots de contact (11) destinés à être mis en contact avec ledit au moins un dispositif électronique (1) par l'intermédiaire des premières molécules d'interaction (5).

8. Organe de manipulation (3) selon la revendication 7, dans lequel les plots de contact (11) sont répartis sur la surface de contact (S2) selon un écartement prédéterminé (D1) correspondant à un écartement entre deux dispositifs optoélectroniques (1) disposés sur un substrat primaire (9).

9. Organe de manipulation (3) selon l'une des revendications 1 à 8, dans lequel les premières molécules d'interaction (5) sont configurées pour interagir par interaction chimique avec les deuxièmes molécules d'interaction (7) lorsque des molécules choisies dans le groupe comprenant la pluralité de premières molécules d'interaction (5) et la pluralité de deuxièmes molécules d'interaction (7) subissent un traitement thermique et/ou un traitement chimique.

10. Procédé de manipulation d'au moins un dispositif électronique (1) à partir d'un substrat primaire (9), le procédé de manipulation comprenant :
- une phase de fourniture d'un système provisoire comprenant un substrat primaire (9) sur lequel est disposé l'au moins un dispositif électronique (1), et un organe de manipulation (3), ledit au moins un dispositif électronique (1) présentant une surface fonctionnelle (S1), et ledit organe de manipulation (3) comprenant un corps présentant une surface de contact (S2), l'organe de manipulation comprenant une pluralité de premières molécules d'interaction (5) attachées à la surface de contact (S2), lesdites premières molécules d'interaction (5) étant en situation d'interaction chimique réversible avec une pluralité de deuxièmes molécules d'interaction (7) qui sont attachées au dispositif électronique (1) au niveau de la surface fonctionnelle (S1) ;
- une étape (E9) de séparation de l'organe de manipulation (3) et de l'au moins un dispositif électronique (1) dans laquelle un traitement physique et/ou chimique est appliqué à des molécules choisies dans le groupe comprenant la pluralité de premières molécules d'interaction (5) et la pluralité de deuxièmes molécules d'interaction (7) de manière à rompre ladite interaction chimique entre la pluralité de premières molécules d'interaction (5) et la pluralité de deuxièmes molécules d'interaction (7) ;
- une étape (E10) de retrait de l'organe de manipulation (3).

11. Procédé de manipulation selon la revendication 10, dans lequel la phase de fourniture d'un système provisoire comprend :
- une étape (E3) de mise à disposition de l'organe de manipulation (3) présentant la surface de contact (S2) ;
- une étape (E4) de fourniture du substrat primaire (9) sur lequel est disposé l'au moins un dispositif électronique (1), lequel présente une surface fonctionnelle (S1) ;
- une étape (E6) de solidarisation temporaire de l'organe de manipulation (3) avec ledit au moins un dispositif électronique (1), par l'intermédiaire de la pluralité de premières molécules d'interaction (5) et de la pluralité de deuxièmes molécules d'interaction (7), lesdites premières et deuxièmes molécules d'interaction (5, 7) interagissant entre elles par interaction chimique réversible.

12. Procédé de manipulation selon l'une quelconque des revendications 10 ou 11, dans lequel le traitement chimique et/ou physique permettant de rompre l'interaction chimique entre la pluralité de premières molécules d'interaction (5) et la pluralité de deuxièmes molécules d'interaction (7) comprend l'émission d'un rayonnement lumineux à une première longueur d'onde.

13. Procédé de manipulation selon la revendication 11, ou selon la revendication 12 lorsqu'elle dépend de la revendication 11, dans lequel l'étape (E6) de solidarisation temporaire est mise en œuvre par une réaction chimique réversible entre la pluralité de premières molécules d'interaction (5) et la pluralité de deuxièmes molécules d'interaction (7).

14. Procédé de manipulation selon la revendication 11 ou 13, ou selon la revendication 12 lorsqu'elle dépend de la revendication 11, dans lequel l'étape (E6) de solidarisation temporaire est mise en œuvre par une réaction de Diels-Alder entre la pluralité de premières molécules d'interaction (5) et la pluralité de deuxièmes molécules d'interaction (7).

15. Procédé de manipulation selon la revendication 12 lorsqu'elle dépend de la revendication 11, ou selon l'une quelconque des revendications 11, 13 ou 14, dans lequel l'étape (E6) de solidarisation temporaire est mise en œuvre par une réaction de chimie click entre la pluralité de premières molécules d'interaction (5) et la pluralité de deuxièmes molécules d'interaction (7).

16. Procédé de manipulation selon l'une quelconque des revendications 10 à 15, dans lequel les premières molécules d'interaction (5) et/ou les deuxièmes molécules d'interaction (7) comprennent au moins une chaîne carbonée.

## Patentansprüche

1. Handhabungselement (3), das mindestens eine elektronische Vorrichtung (1) handhaben kann, wobei das Handhabungselement (3) einen Körper umfasst, der eine Kontaktfläche (S2) aufweist, wobei das Handhabungselement (3) weiter eine Vielzahl von ersten Interaktionsmolekülen (5) umfasst, die eine Fähigkeit aufweisen, an die Kontaktfläche (S2) zu gebunden zu werden, wobei die ersten Interaktionsmoleküle (5) dazu bestimmt sind, durch reversible chemische Interaktion mit einer Vielzahl von zweiten Interaktionsmolekülen (7), die an eine funktionale Oberfläche (S1) der mindestens einen elektronischen Vorrichtung (1) gebunden werden können, zu interagieren, wobei die chemische Interaktion so gestaltet ist, dass sie eine vorübergehende feste Verbindung zwischen der mindestens einen elektronischen Vorrichtung (1) und dem Handhabungselement (3) sicherstellt, wobei die chemische Interaktion durch Anwendung einer chemischen und/oder physikalischen Behandlung auf Moleküle, ausgewählt aus der Gruppe, die die Vielzahl von ersten Interaktionsmolekülen (5) und die Vielzahl von zweiten Interaktionsmolekülen (7) umfasst, auf eine Weise unterbrochen werden kann, die es ermöglicht, die mindestens eine elektronische Vorrichtung (1) und das Handhabungselement (3) infolge der Anwendung der chemischen und/oder physikalischen Behandlung zu trennen.

2. Handhabungselement (3) nach Anspruch 1, wobei die chemische und/oder physikalische Behandlung, die es ermöglicht, die mindestens eine elektronische Vorrichtung (1) und das Handhabungselement (3) zu trennen, die Emission einer Lichtstrahlung mit einer ersten Wellenlänge umfasst.

3. Handhabungselement (3) nach Anspruch 2, wobei die Lichtstrahlung mit der ersten Wellenlänge durch das Bedienelement (3) oder durch das Bedienelement (3) hindurch emittiert wird.

4. Handhabungselement (3) nach einem der Ansprüche 2 oder 3, wobei die ersten Interaktionsmoleküle (5) so gestaltet sind, dass sie durch chemische Interaktion mit den zweiten Interaktionsmolekülen (7) interagieren, wenn Moleküle, ausgewählt aus der Gruppe, die die Vielzahl von ersten Interaktionsmolekülen (5) und die Vielzahl von zweiten Interaktionsmolekülen (7) umfasst, einer Behandlung mit Lichtstrahlung mit einer zweiten Wellenlänge unterzogen werden, die sich von der ersten Wellenlänge unterscheidet.

5. Handhabungselement (3) nach einem der Ansprüche 2 bis 4, wobei die elektronische Vorrichtung (1) eine optoelektronische Vorrichtung ist, die Licht mit der ersten Wellenlänge emittieren kann, wobei die ersten Interaktionsmoleküle (5) so gestaltet sind, dass sie ihre chemische Interaktion mit den zweiten Interaktionsmolekülen (7) unterbrechen, wenn die ersten Interaktionsmoleküle (5) einer Lichtstrahlung mit der ersten Wellenlänge ausgesetzt werden.

6. Handhabungselement (3) nach einem der Ansprüche 2 bis 5, wobei die erste Wellenlänge im Bereich zwischen 400 nm und 800 nm liegt und insbesondere im Wesentlichen gleich 420 nm, oder im Wesentlichen gleich 450 nm, oder im Wesentlichen gleich 470 nm ist.

7. Handhabungselement (3) nach einem der Ansprüche 1 bis 6, wobei die Kontaktfläche (S2) des Körpers Kontaktstücke (11) aufweist, die dazu bestimmt sind, mittels der ersten Interaktionsmoleküle (5) mit der mindestens einen elektronischen Vorrichtung (1) in Kontakt gebracht zu werden.

8. Handhabungselement (3) nach Anspruch 7, wobei die Kontaktstücke (11) auf der Kontaktfläche (S2) in einem vorbestimmten Abstand (D1), der einem Abstand zwischen zwei auf einem Primärsubstrat (9) angeordneten optoelektronischen Vorrichtungen (1) entspricht, verteilt sind.

9. Handhabungselement (3) nach einem der Ansprüche 1 bis 8, wobei die ersten Interaktionsmoleküle (5) so gestaltet sind, dass sie durch chemische Interaktion mit den zweiten Interaktionsmolekülen (7) interagieren, wenn Moleküle, ausgewählt aus der Gruppe, die die Vielzahl von ersten Interaktionsmolekülen (5) und die Vielzahl von zweiten Interaktionsmolekülen (7) umfasst, einer Wärmebehandlung und/oder einer chemischen Behandlung unterzogen werden.

10. Verfahren zur Handhabung mindestens einer elektronischen Vorrichtung (1) auf Grundlage eines Primärsubstrats (9), wobei das Handhabungsverfahren umfasst:
- eine Phase des Bereitstellens eines provisorischen Systems, das ein Primärsubstrat (9) umfasst, auf dem die mindestens eine elektronische Vorrichtung (1) angeordnet ist, und eines Handhabungselements (3), wobei die mindestens eine elektronische Vorrichtung (1) eine funktionale Oberfläche (S1) aufweist, und das Handhabungselement (3) einen Körper umfasst, der eine Kontaktfläche (S2) aufweist, wobei das Handhabungselement eine Vielzahl von ersten Interaktionsmolekülen (5) umfasst, die an die Kontaktfläche (S2) gebunden sind, wobei sich die ersten Interaktionsmoleküle (5) in Situation einer reversiblen chemischen Interaktion mit einer Vielzahl von zweiten Interaktionsmolekülen (7) befinden, die auf Ebene der funktionellen Oberfläche (S1) an die elektronische Vorrichtung (1) gebunden sind;
- einen Schritt (E9) des Trennens des Handhabungselements (3) und der mindestens einen elektronischen Vorrichtung (1), bei dem eine physikalische und/oder chemische Behandlung auf Moleküle, ausgewählt aus der Gruppe, die die Vielzahl von ersten Interaktionsmolekülen (5) und die Vielzahl von zweiten Interaktionsmolekülen (7) umfasst, angewendet wird, um die chemische Interaktion zwischen der Vielzahl von ersten Interaktionsmolekülen (5) und der Vielzahl von zweiten Interaktionsmolekülen (7) zu unterbrechen;
- einen Schritt (E10) des Entfernens des Handhabungselements (3).

11. Handhabungsverfahren nach Anspruch 10, wobei die Phase des Bereitstellens eines provisorischen Systems umfasst:
- einen Schritt (E3) des Bereitstellens des Handhabungselements (3), das die Kontaktfläche (S2) aufweist;
- einen Schritt (E4) des Bereitstellens des Primärsubstrats (9), auf dem die mindestens eine elektronische Vorrichtung (1) angeordnet ist, die eine funktionale Oberfläche (S1) aufweist;
- einen Schritt (E6) des vorübergehenden festen Verbindens des Handhabungselements (3) mit der mindestens einen elektronischen Vorrichtung (1) mittels der Vielzahl von ersten Interaktionsmolekülen (5) und der Vielzahl von zweiten Interaktionsmolekülen (7), wobei die ersten und die zweiten Interaktionsmoleküle (5, 7) durch reversible chemische Interaktion miteinander interagieren.

12. Handhabungsverfahren nach einem der Ansprüche 10 oder 11, wobei die chemische und/oder physikalische Behandlung, die es ermöglicht, die chemische Interaktion zwischen der Vielzahl von ersten Interaktionsmolekülen (5) und der Vielzahl von zweiten Interaktionsmolekülen (7) zu unterbrechen, die Emission einer Lichtstrahlung mit einer ersten Wellenlänge umfasst.

13. Handhabungsverfahren nach Anspruch 11 oder nach Anspruch 12 in Abhängigkeit von Anspruch 11, wobei der Schritt (E6) des vorübergehenden festen Verbindens durch eine reversible chemische Reaktion zwischen der Vielzahl von ersten Interaktionsmolekülen (5) und der Vielzahl von zweiten Interaktionsmolekülen (7) umgesetzt wird.

14. Handhabungsverfahren nach Anspruch 11 oder 13 oder nach Anspruch 12 in Abhängigkeit von Anspruch 11, wobei der Schritt (E6) des vorübergehenden festen Verbindens durch eine Diels-Alder-Reaktion zwischen der Vielzahl von ersten Interaktionsmolekülen (5) und der Vielzahl von zweiten Interaktionsmolekülen (7) umgesetzt wird.

15. Handhabungsverfahren nach Anspruch 12 in Abhängigkeit von Anspruch 11, oder nach einem der Ansprüche 11, 13 oder 14, wobei der Schritt (E6) des vorübergehenden festen Verbindens durch eine chemische Klick-Reaktion zwischen der Vielzahl von ersten Interaktionsmolekülen (5) und der Vielzahl von zweiten Interaktionsmolekülen (7) umgesetzt wird.

16. Handhabungsverfahren nach einem der Ansprüche 10 bis 15, wobei die ersten Interaktionsmoleküle (5) und/oder die zweiten Interaktionsmoleküle (7) mindestens eine Kohlenstoffkette umfassen.

## Claims

1. A handling member (3) capable of handling at least one electronic device (1), said handling member (3) comprising a body having a contact surface (S2), said handling member (3) further comprising a plurality of first interacting molecules (5) having an ability to be attached to the contact surface (S2), said first interacting molecules (5) being intended to interact by reversible chemical interaction with a plurality of second interacting molecules (7) capable of being attached to a functional surface (S1) of said at least one electronic device (1), said chemical interaction being configured to ensure a temporary securement between said at least one electronic device (1) and the handling member (3), said chemical interaction being likely to be broken by applying a chemical and/or physical treatment to molecules selected from the group comprising the plurality of first interacting molecules (5) and the plurality of second interacting molecules (7), in a manner making it possible to separate said at least one electronic device (1) and the handling member (3) following the application of said chemical and/or physical treatment.

2. Handling member (3) according to claim 1, wherein the chemical and/or physical treatment making it possible to separate said at least one electronic device (1) and the handling member (3) comprises the emission of light radiation at a first wavelength.

3. Handling member (3) according to claim 2, wherein the light radiation at the first wavelength is emitted by the handling member (3), or through the handling member (3).

4. Handling member (3) according to any of claims 2 or 3, wherein the first interacting molecules (5) are configured to interact by chemical interaction with the second interacting molecules (7) when molecules selected from the group comprising the plurality of first interacting molecules (5) and the plurality of second interacting molecules (7) undergo a treatment by light radiation at a second wavelength different from the first wavelength.

5. Handling member (3) according to any one of claims 2 to 4, wherein the electronic device (1) is an optoelectronic device capable of emitting light at the first wavelength, the first interacting molecules (5) being configured to break their chemical interaction with the second interacting molecules (7) when the first interacting molecules (5) are subjected to light radiation at the first wavelength.

6. Handling member (3) according to any one of claims 2 to 5, wherein the first wavelength is comprised between 400 nm and 800 nm and is in particular substantially equal to 420 nm, or substantially equal to 450 nm, or substantially equal to 470 nm.

7. Handling member (3) according to any one of claims 1 to 6, wherein the contact surface (S2) of the body has contact pads (11) intended to be brought into contact with said at least one electronic device (1) through the first interacting molecules (5).

8. Handling member (3) according to claim 7, wherein the contact pads (11) are distributed over the contact surface (S2) according to a predetermined spacing (D1) corresponding to a spacing between two optoelectronic devices (1) disposed on a primary substrate (9).

9. Handling member (3) according to any of claims 1 to 8, wherein the first interacting molecules (5) are configured to interact by chemical interaction with the second interacting molecules (7) when molecules selected from the group comprising the plurality of first interacting molecules (5) and the plurality of second interacting molecules (7) undergo a thermal treatment and/or a chemical treatment.

10. A method for handling at least one electronic device (1) from a primary substrate (9), the handling method comprising:
- a phase of providing a temporary system comprising a primary substrate (9) on which the at least one electronic device (1) is disposed, and a handling member (3), said at least one electronic device (1) having a functional surface (S1), and said handling member (3) comprising a body having a contact surface (S2), the handling member comprising a plurality of first interacting molecules (5) attached to the contact surface (S2), said first interacting molecules (5) being in a situation of reversible chemical interaction with a plurality of second interacting molecules (7) which are attached to the electronic device (1) at the functional surface (S1);
- a step (E9) of separating the handling member (3) and the at least one electronic device (1) in which a physical and/or chemical treatment is applied to molecules selected from the group comprising the plurality of first interacting molecules (5) and the plurality of second interacting molecules (7) so as to break said chemical interaction between the plurality of first interacting molecules (5) and the plurality of second interacting molecules (7);
- a step (E10) of removing the handling member (3).

11. Method for handling according to claim 10, wherein the phase of providing a temporary system comprises:
- a step (E3) of making available the handling member (3) having the contact surface (S2);
- a step (E4) of providing the primary substrate (9) on which the at least one electronic device (1) is disposed, which has a functional surface (S1);
- a step (E6) of temporarily securing the handling member (3) with said at least one electronic device (1), through the plurality of first interacting molecules (5) and the plurality of second interacting molecules (7), said first and second interacting molecules (5, 7) interacting with each other by reversible chemical interaction.

12. Method for handling according to any one of claims 10 or 11, wherein the chemical and/or physical treatment making it possible to break the chemical interaction between the plurality of first interacting molecules (5) and the plurality of second interacting molecules (7) comprises the emission of light radiation at a first wavelength.

13. Method for handling according to claim 11, or according to claim 12 when it depends on claim 11, wherein the temporary securement step (E6) is implemented by a reversible chemical reaction between the plurality of first interacting molecules (5) and the plurality of second interacting molecules (7).

14. Method for handling according to claim 11 or 13, or according to claim 12 when it depends on claim 11, wherein the temporary securement step (E6) is implemented by a Diels-Alder reaction between the plurality of first interacting molecules (5) and the plurality of second interacting molecules (7).

15. Method for handling according to claim 12 when it depends on claim 11, or according to any one of claims 11, 13 or 14, wherein the temporary securement step (E6) is implemented by a click chemistry reaction between the plurality of first interacting molecules (5) and the plurality of second interacting molecules (7).

16. Method for handling according to any one of claims 10 to 15, wherein the first interacting molecules (5) and/or the second interacting molecules (7) comprise at least one carbon chain.
